# EUROPEAN PATENT APPLICATION

(11) **EP 2 884 554 A1**
(43) Date of publication of application: **17.06.2015**
(21) Application number: 14195833.0
(22) Date of filing: 02.12.2014
(51) Int. Cl.: H01L 51/52, H01L 27/32

(54) **Organic electroluminescence device**

(30) Priority: 06.12.2013 JP 2013252975
(71) Applicant: Futaba Corporation, Mobara-shi Chiba 297-8588 (JP)
(72) Inventor: Kodama, Mitsufumi, Mobara-shi, Chiba 297-8588 (JP); Ishiguro, Shigeyuki, Mobara-shi, Chiba 297-8588 (JP); Naritomi, Shigeo, Mobara-shi, Chiba 297-8588 (JP); Ide, Shinji, Mobara-shi, Chiba 297-8588 (JP)
(74) Representative: Epping - Hermann - Fischer

(57) **Abstract**

A highly reliable organic electroluminescence device is provided. An organic electroluminescence device (1) includes at least one layer of inorganic barrier film (4), at least one organic electroluminescence element (5), and a sealed portion. The inorganic barrier film (4) is formed to contact to a flexible substrate (2) or at least one layer of organic resin film (3) formed on the substrate (2). The organic electroluminescence element (5) is formed on the inorganic barrier film (4) and includes an anode (51), an organic layer (52) including an organic light emitting layer, and a cathode (53). The sealed portion includes at least one of a flexible sealing film (8) and a sealing membrane (6), and blocks at least one organic electroluminescence element (5) from the air outside. The formed surface of the inorganic barrier film (4) is held to maintain a state in which a compressive stress is applied.

## Description

### Technical Field

The present disclosure relates to an organic electroluminescence device (organic light emitting device (OLED)).

### Background Art

An organic electroluminescence device such as an organic electroluminescence display and the like has low environmental resistance such as moisture resistance and the like. Thus, when an organic electroluminescence device is manufactured, it is important to protect the device from the surrounding environment such as air. Especially, when a resin film is used for the substrate, permeability of water through the film is a problem, and a barrier film must be formed as a moisture-proof film whose major ingredient is inorganic material. For example, the Patent Literature 1 discloses a method for improving air permeability resistance and moisture permeability resistance by disposing a silicon monoxide (SiO) thin film on the resin film.

However, if the thickness of the thin film is increased in order to increase the air permeability resistance and moisture permeability resistance of the thin film composed of an inorganic material formed on the resin film, when the resin film is bent, cracks readily form in the thin film. Therefore, the Patent Literature 2 discloses a method for alleviating stresses of the film and the barrier film by disposing a stress alleviating film having a smaller stress than that of the barrier film.

### Citation List

### Patent Literature

Patent Literature 1: Examined Japanese Patent Application Publication No. S53-12953
Patent Literature 2: Unexamined Japanese Patent Application Kokai Publication No. 2003-86356.

### Summary of Invention

### Technical Problem

However, in the barrier film, there are defects such as micro-pinhole defects and defects that cannot be recognized shortly after the film was manufactured but later become recognizable defects during actual use. Such potential defects are difficult to completely remove by an inspection process. Thus, in order to provide a highly reliable organic electroluminescence device, potential defects must be prevented from becoming manifest.

The present disclosure was made in consideration of the above mentioned problem, and the purpose of the present disclosure is to provide a highly reliable organic electroluminescence device.

### Solution to Problem

In order to achieve the above mentioned purpose, the organic electroluminescence device of the present disclosure includes:
at least one layer of an inorganic barrier film formed to contact a flexible substrate or to contact at least one layer of organic resin film formed on the substrate;
at least one organic electroluminescence element formed on the inorganic barrier film and including an anode, an organic layer including an organic light emitting layer and, a cathode; and
a sealed portion including at least one of a flexible sealing film and a sealing membrane, and blocking the at least one organic electroluminescence element from outside air;
wherein the inorganic barrier film being held to maintain a state in which a compressive stress is applied.

The inorganic barrier film is preferably held such that the formed surface thereof is more concave than the surface in the freely-left-state in which the film is left without external force being applied.

The organic electroluminescence device preferably includes a layer in a liquid state, gelled state or flexible solid state, the layer having a drying function and being disposed between the at least one organic electroluminescence element or the sealing membrane and the flexible sealing film.

### Advantageous Effects of Invention

According to the present disclosure, a highly reliable organic electroluminescence device can be provided.

### Brief Description of Drawings

FIG. 1 is an explanatory drawing showing an example of an organic electroluminescence device according to the present disclosure;
FIG. 2 is an explanatory drawing showing the bent condition of an organic electroluminescence device; and
FIG. 3 is an explanatory drawing showing an organic EL element according to Example 1.

### Description of Embodiments

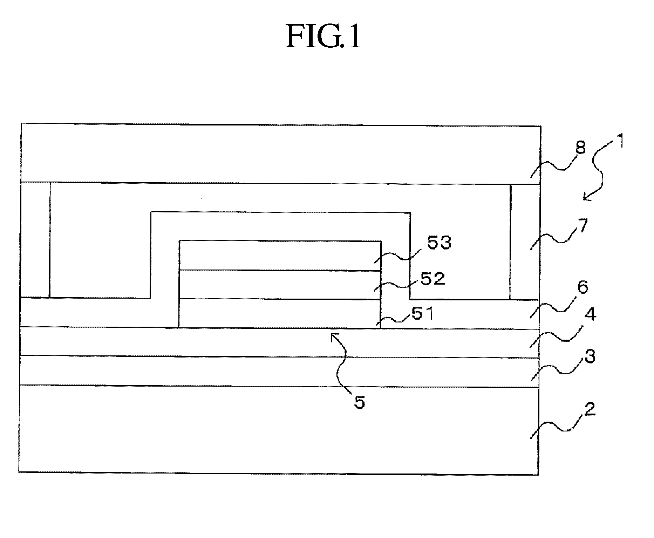

Hereinafter, the organic electroluminescence device (organic EL device) according to the present disclosure is described in reference to the drawings. FIG. 1 is a diagram showing an example of the organic EL device according to the present disclosure.

As shown in FIG. 1, an organic EL device 1 includes a substrate 2, an organic resin film 3, an inorganic barrier film 4, an organic EL element 5, a sealing membrane 6, an adhesive material 7 and a sealing film 8.

A flexible resin film is preferably used as the substrate 2. A resin film is used that includes one or a plurality of types of materials selected, for example, from polyethylene terephthalate (PET), polyether sulfone (PES), polyethylene naphthalate (PEN), polycarbonate (PC), nylon, polyether ether ketone (PEEK), polysulfone (PSF), polyether imide (PEI), polyarylate (PAR), polybutylene terephthalate (PBT), and polyimide.

The organic resin film 3 is formed on the substrate 2 and includes one layer or a plurality of layers. There is no need to form the organic resin film 3 on the substrate 2. Acrylic resin, cycloolefin resin, polyimide resin, silicone resin or the like is used for the organic resin film 3.

The thickness of the organic resin film 3 is preferably 0.5 to 100 micrometers. If the thickness is less than 0.5 micrometers, the planarization ability of the surface of the organic resin film 3 is insufficient. If the thickness is more than 100 micrometers, drying time becomes prolonged and drying irregularities are readily generated.

The inorganic barrier film 4 is formed on the organic resin film 3 such that the inorganic barrier film 4 directly contacts the organic resin film 3. The inorganic barrier film 4 includes one layer or a plurality of layers. In addition to SiO₂, SiON (silicon oxynitride), SiNx (silicon nitride), Al₂O₃ (aluminum oxide: alumina) and the like are used for the inorganic barrier film from the standpoint of not only its moisture-proof performance but also availability and economic performance.

The thickness of the inorganic barrier film 4 is preferably 0.5 to 10 micrometers. If the thickness is less than 0.5 micrometers, the defect density is increased. If the thickness is more than 10 micrometers, cracks may readily occur because the stiffness of the inorganic barrier film 4 increases excessively and the film becomes brittle.

The inorganic barrier film 4 is preferably formed using the plasma CVD method. The inorganic barrier film 4 formed using the plasma CVD method, in addition to having a small number of defects, is extremely resistant to permeation by water vapor and has a barrier performance indicated by a water vapor permeation rate less than or equal to 1 x 10⁻⁵ g/m²·day.

Adhesion between the organic resin film 3 and the inorganic barrier film 4 is very important. Pretreatment conditions must be considered, such as the film forming conditions, pre-film-formation cleaning conditions or the like. If adhesive force is insufficient, defects due to the interface between the organic resin film 3 and the inorganic barrier film 4 easily occur, and the inorganic barrier film 4 may peel off from this interface due to stress changes caused by heat or the like during processing.

The formed face of the inorganic barrier film 4 is held such that a state in which a compressive stress is applied is maintained. Traditionally when a stress is generated in the inorganic barrier film 4, as described, for example, in the Patent Literature 2, a means to alleviate the stress is arranged to flatten the formed face. However, in the present disclosure, the formed face is held such that a condition is actively maintained in which a compressive stress is applied to the inorganic barrier film 4. Inorganic material films such as the inorganic barrier film 4 have a high break strength under compressive stress and have a low break strength under tensile stress. Therefore, since compressive stress remains, even though the inorganic barrier film 4 is deformed, defects do not readily occur, new formation of water-penetration-induced dark spots due to the defects in the inorganic barrier film 4 is prevented, and the inorganic barrier film 4 can maintain good display quality for a long time. Thus an appropriate compressive stress is applied to the inorganic barrier film 4 to prevent latent defects of the inorganic barrier film 4, and defects of the inorganic barrier film 4 caused by the deformation due to an eternal stress, and reliability is increased. Such an appropriate compressive stress is 1 x 10⁸ dyn/cm² to 5 x 10¹⁰ dyn/cm².

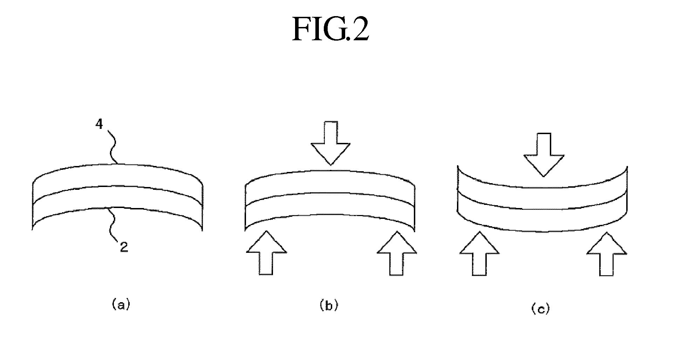

For example, if the inorganic barrier film 4 is formed on the organic resin film 3, as shown in FIG. 2 (a), a compressive stress making the inorganic barrier film 4 convex arises due to: difference of the thermal expansion coefficient between the inorganic barrier film 4 and the substrate 2, thermal contraction of the film due to heat when the film is formed, internal stresses (film forming method, film composition, impurities, film density, crystallization, ion implantation and free energy at the interface between the substrate and the thin film) and the like. For example, when a SiON film is laminated on the organic resin film 3 using the plasma CVD method (temperature: 120 to 170 degrees C), contraction and thermal relaxation of the substrate 2 occur. When the temperature returns to a room temperature after the inorganic barrier film 4 is formed, a compressive stress making the inorganic barrier film 4 convex arises. When an organic EL device is manufactured using the substrate 2 on which such an inorganic barrier film 4 has been formed, the substrate 2 deforms to become convex toward the inorganic barrier film 4 side to relax the compressive stress of the inorganic barrier film 4. As shown in FIGS. 2(b) and 2(c), using the convexly deformed substrate 2, the organic EL device 1 is disposed such that the curvature radius thereof is increased, or the organic EL device 1 is formed to be a plane, or further the organic EL device 1 is deformed to be concave. That is, the inorganic barrier film 4 is held such that the formed surface thereof is more concave than the surface in the freely-left-state in which the film is left without external force being applied. Therefore, the formed face of the inorganic barrier film 4 is held in such a condition that the application of compressive stress is maintained.

As long as temperature does not exceed the upper temperature limit of the substrate 2, one or more organic EL elements 5 of a desired structure and shape can be formed by the usual manufacturing processes used for an organic EL element. An electrode layer and/or wired layer can be directly formed on the inorganic barrier film 4 of the organic EL element 5. Then, the subsequent manufacturing processes of an organic EL element such as interlayer insulation film formation can also be performed without large changes except in temperature. For example, a white light emitting organic EL device can be formed by utilizing white light emitting organic EL elements, and a further effective organic EL device can be formed by utilizing tandem type organic EL elements.

In the organic EL element 5, at least one organic EL element is formed which at least includes an anode 51, an organic layer 52 including an organic light emitting layer, and a cathode 53.

The anode 51 is connected to an external power source (not shown) and functions to provide holes to the organic layer 52. The anode 51 is formed of a transparent material, and metal, alloy or an electrically conductive compound having a relatively large work function is preferably used as the electrode material for the anode 51. The electrode material used for the anode 51 is exemplified by gold, platinum, silver, copper, cobalt, nickel, palladium, vanadium, tungsten, tin oxide, zinc oxide, indium-tin-oxide (ITO), indium-zinc-oxide (IZO), polythiophene, and polypyrrole. These electrode materials can be used as a single material, or multiple materials can be used in combination.

The organic layer 52 includes an organic light emitting layer. The organic light emitting layer is a layer which includes a compound that functions to inject holes and electrons, to transport such, and to generat excitons by the recombination of holes and electrons (light emitting function). Materials used for the organic light emitting layer include coumalin derivatives, quinacridone, rubrene, styryl type dyes, quinoline derivatives such as organic materials having a quinolinol ring such as tris(8-quinolinolato)aluminum or organic metal complexes in which organic material having a quinolinol ring is coordinated, tetraphenylbutadiene, anthracene derivatives, naphthacene derivatives, perylene, coronene, 12-phthaloperynone derivatives, phenyl anthracene derivatives, tetraarylethene derivatives, fluoranthene derivatives, acenaphthofluoranthene derivatives, and aromatic amine compounds such as tetraphenyldiaminobiphenyl derivatives (TPD), triarylamine derivatives and the like. The organic layer 52 may include a hole transporting layer, a hole injection layer, an electron transporting layer and/or an electron injection layer as needed.

The cathode 53 is connected to an external power source (not shown) and provides electrons to the organic layer 52. Metal, alloy or an electrically conductive compound having a relatively small work function is preferably used for an electrode material for the cathode 53. The electrode materials used for the cathode 53 are, for example, lithium, lithium-indium alloy, sodium, calcium, magnesium, magnesium-silver alloy, magnesium-indium alloy, indium, ruthenium, titanium, manganese, yttrium, aluminum, aluminum-lithium alloy, aluminum-calcium alloy, aluminum-magnesium alloy, graphite thin films and the like. These electrode materials can be used as a single material, or multiple materials can be used in combination.

Any sealing membrane generally used for an organic EL device 1 can be utilized as the sealing membrane 6. For example, silicon oxide film, silicon oxynitride film, silicon nitride film, inorganic layers such as aluminum oxide and magnesium oxide, and organic layers can be cited. One of these films may be formed alone, or multiple films may be laminated together. From the standpoint of forming a sealing membrane 6 that has a low moisture permeability and is highly electrically insulating, a ceramic film is preferably used that is formed by the CVD method or by the PVD method.

The adhesive material 7 bonds together the sealing membrane 6 and the sealing film 8. The adhesive material 7 preferably includes an adhesive generally used in organic EL devices, particularly a curable adhesive. Usage of the sealing film 8 can effectively prevent moisture, oxygen or the like from entering, compared to use of a sealing membrane 6 alone. Thermosetting type adhesives and photo-setting type adhesives and the like are examples of curable adhesives. Epoxy resins, acrylic resins and the like are used as curable adhesives.

Any flexible sealing film generally used in an organic EL device 1 can be utilized as the sealing film 8. Resin films can be cited which include one or a plurality of types of materials selected from polyethylene terephthalate (PET), polyether sulfone (PES), polyethylene naphthalate (PEN), polycarbonate (PC), nylon, polyether ether ketone (PEEK), polysulfone (PSF), polyether imide (PEI), polyarylate (PAR), polybutylene terephthalate (PBT), and polyimide. The sealing film 8 may be formed from one type of resin film, or may be formed by lamination of multiple types of resin films. The inorganic barrier film 4 may further be formed on the sealing film 8. By such configurations, the air permeability resistance and moisture permeability resistance of the organic EL device 1 can further be increased. If the organic EL element 5 can be shielded from outside air, either the sealing membrane 6 or the sealing film 8 may be omitted.

A layer in a liquid state, gelled state or flexible solid state and having a drying function is preferably included between the organic EL element 5 or the sealing membrane 6 and the sealing film 8.

In the organic EL device 1 configured in this manner, the inorganic barrier film 4 is retained in a manner so as to maintain the application of compressive stress. Thus, compressive stress is applied to the inorganic barrier film 4, and the new formation of dark spots due to the inorganic barrier film 4 becomes difficult. As a result, the organic EL device 1 can maintain good display quality over a long period of time in the whole operating environmental temperature range.

This occurs because the inorganic barrier film 4 on the substrate 2 is in the state in which the inorganic barrier film 4 is convexly bent (here the bent state of the organic EL device 1 with no force applied is termed the "freely-left-state") and the total stress applied to the formed inorganic barrier film 4 becomes compressive, so that the inorganic barrier film 4 bends convexly to alleviate the compressive stress. Therefore, in the present disclosure, the organic EL device 1 is disposed such that an appropriate compressive stress is constantly applied to the alleviated inorganic barrier film 4 in the operating environment. This means that the organic EL device 1 is disposed such that, viewed from the inorganic barrier film 4 side, degree of curvature of the convexity increases, the organic EL device 1 becomes planar, or the organic EL device 1 becomes concave compared with the freely-left-state in the actual operating temperature range. That is, the inorganic barrier film 4 is held such that the formed surface thereof is more concavecompared with the freely-left-state in which the inorganic barrier film 4 is left without any external force being applied. In this state, a large compressive stress is applied to the inorganic barrier film 4 compared with the freely-left-state. Alternatively, stresses at the time of forming each thin film may be designed and determined such that an appropriate stress is applied to the organic EL device 1 in the disposed shape. This prevents latent defects of the inorganic barrier film 4 and defects of the inorganic barrier film 4 due to deformation caused by an external force, so that reliability improves.

### [Examples]

Specific examples of the present disclosure are described below to further explain the present disclosure in detail.

### [Example 1]

Firstly, polyethylene terephthalate (PET) film was prepared as the substrate 2, was pasted together with a slightly sticky sheet, and was temporarily fixed to a glass substrate. Then acrylic resin as the organic resin film 3 was coated and cured on the PET film surface, and the surface thereof was cleaned. Then silicon oxide (SiO₂) film composing the inorganic barrier film 4 was formed on the resin film at 100 degrees C by sputtering. Further, SiON or SiNx was stacked to form the inorganic barrier film 4 by the plasma CVD method. Temperature during such film formation was set to 120 to 170 degrees C.

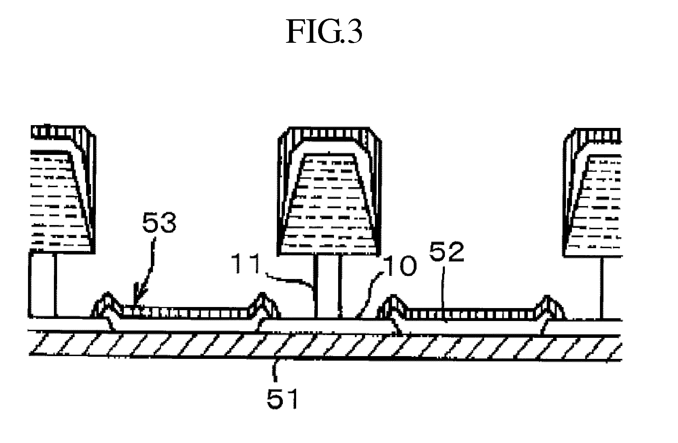

A process such as the following was applied to the substrate 2, which was temporarily fixed to the glass substrate. Multiple organic EL elements 5 (display panel), as shown in FIG. 3, were formed on a substrate.

Indium-tin-oxide (ITO), which is a transparent conductive film, was formed as the anode 51 of approximately 1,500 angstrom thickness by sputtering. Then, after the ITO resist pattern was formed by photolithography, the unnecessary part was removed by etching, and the resist was peeled off to make ITO of a desired electrode pattern. Then, a polyimide layer, as the insulation film layer 10 for carrying a subsequently formed spacer, was formed on the ITO.

A non-photosensitive material was selected for the polyimide. The material was diluted with N-methyl pyrrolidone (NMP) and/or gamma-butyrolactone to approximately 5% concentration, was applied by the spin-coat process and was prebaked at 145 degrees C for one hour. After application and patterning of positive resist, the exposed resist part was then removed using an approximately 2.38% aqueous solution of tetramethyl ammonium hydride (TMAH), which is a developer solution for the resist. Finally, a desired polyimide layer was formed by using ethanol to remove only the resist, and the polyimide layer was completely cured at approximately 350 degrees C so as to not be permeated by reagent solutions used later.

Then, a spacer film was formed. A SOG, resin film, or the like is used for the material of the spacer film. When polyimide is selected as the spacer film, the polyimide, whose concentration is adjusted to 15%, is spin-coated to become 2 micrometer thick and is prebaked at 145 degrees C for one hour to form a spacer film. After the spacer film was formed in such a manner, a positive resist was applied. After application of the positive resist coating in such a manner, the spacer film was exposed to form a desired photo pattern, was developed, and an umbrella-shaped (generally overhung shape) photosensitive resin was formed. The polyimide spacer film exposed when the positive resist was developed was then also removed by developer after the positive resist to form a spacer 11. Then the organic EL elements shown in FIG. 3 were formed by evaporation and deposition without breaking vacuum, in order, of the following: the compound N, N'-bis(m-methyl phenyl)-N,N'-diphenyl-1,1'-biphenyl-4,4'-diamine (TPD) as an organic layer 52; tris(S-hydroxyquinoline)aluminum (Alq3) as a light emitting layer and as an electron transporting layer; and Mg/Ag alloy (weight ratio 10:1) as a cathode 53.

A sealing membrane 6 was laminated on the organic EL elements and further, an adhesive material 7 was applied to the periphery of the sealing membrane 6, and a sealing film 8, having a liquid desiccant applied to the center thereof, was applied and attached. Then the substrate 2 on which the organic EL elements (display panel) was formed was peeled from the glass substrate and divided into panel pieces. The organic EL device 1 was completed by mounting a flexible print circuit substrate (FPC) on which an IC was mounted.

It was confirmed that the inorganic barrier film 4 was held such that the inorganic barrier film 4 maintained a state in which a compressive stress was applied in the completed organic EL device 1. Due to the application of compressive stress to the inorganic barrier film 4 in this manner, the new formation of dark spots due to the inorganic barrier film 4 becomes difficult. It was thus confirmed that the formed organic EL device 1 could maintain good display quality over a long period of time in the whole operating environment temperature range.

### [Example 2]

Example 2 shows an example of manufacturing of a film color organic EL device display.

First of all, polyethylene naphthalate (PEN) film was prepared as the substrate 2, was pasted to a slightly sticky sheet and the assembly was temporarily fixed to a glass substrate. A PEN film is rather expensive compared with a PET film. However, PEN film is preferred because PEN film has good characteristics for this application, such as excellent heat resistance and low vapor permeability, so that manufacturing process conditions can be more flexibly and favorably determined.

Then the patterns of a black matrix and color filter were formed on the surface of the PEN film in the same manner in the production of a liquid crystal display. Subsequently, cycloolefin resin as an overcoat and as the organic resin film 3 was applied on the color filter, was thermally cured and the surface thereof was cleaned. Then SiON composing the inorganic barrier film 4 was laminated using the plasma CVD method at 150 to 180 degrees C. Compared with SiNx film, SiON film has high light transmittance, particularly in the visible light short wavelength region. The PEN film also contracted and thermally relaxed due to the formation of the SiON film at this temperature, and once temperature returned to room temperature after film formation, the inorganic barrier film 4 generally became to have a compressive stress.

By processing in the same manner as in Example 1, multiple organic EL elements (display panel) were formed on the face of the substrate 2, which was temporarily fixed to the glass substrate.

The sealing membrane 6 was laminated onto the organic EL elements and further, the adhesive material 7 was applied to the periphery of the sealing membrane 6, and the sealing film 8, having a liquid desiccant applied to the center thereof, was pasted. Then the substrate 2, on which the organic EL elements (display panel) were formed, was peeled from the glass substrate and was divided into panel pieces. The organic EL device 1 was completed by mounting a flexible print circuit substrate (FPC) on which an IC was mounted. The IC may be directly mounted on the wiring formed on the PEN film. The film color organic EL display module was pasted on a curved transparent cover on which a touch panel was formed or pasted using an optical transparent double-sided tape or an optically transparent resin, and further, a protective resin was applied thereon to form a display part module.

It was confirmed that, in the completed organic EL device 1, the inorganic barrier film 4 was held such that the inorganic barrier film 4 maintained a state in which a compressive stress was applied thereto. Due to the application of compressive stress to the inorganic barrier film 4 in this manner, the new formation of dark spots due to the inorganic barrier film 4 becomes difficult. Thus, it was confirmed that the formed organic EL device 1 can maintain good display quality over a long period of time in the whole operating environment temperature range.

### Reference Signs List

- 1: Organic EL device

- 2: Substrate
- 3: Organic resin film
- 4: Inorganic barrier film
- 5: Organic EL element
- 6: Sealing membrane
- 7: Adhesive material
- 8: Sealing film
- 51: Anode
- 52: Organic layer
- 53: Cathode

## Claims

1. An organic electroluminescence device comprising:
at least one layer of an inorganic barrier film formed to contact a flexible substrate or to contact at least one layer of organic resin film formed on the substrate;
at least one organic electroluminescence element formed on the inorganic barrier film and including an anode, an organic layer comprising an organic light emitting layer, and a cathode; and
a sealed portion comprising at least one of a flexible sealing film and a sealing membrane, and blocking the at least one organic electroluminescence element from outside air;
wherein the inorganic barrier film is held to maintain a state in which a compressive stress is applied.

2. The organic electroluminescence device according to Claim 1, wherein
the inorganic barrier film is held such that the formed surface thereof is more concave than the surface in the freely-left-state in which the film is left without external force being applied.

3. The organic electroluminescence device according to Claim 1 or 2, comprising a layer in a liquid state, gelled state or flexible solid state, the layer having a drying function and being disposed between the at least one organic electroluminescence element or the sealing membrane and the flexible sealing film.
